## Europäisches Patentamt

## European Patent Office

## Office européen des brevets

(11) Veröffentlichungsnummer: **0 345 427**

**A2**

(12) **EUROPÄISCHE PATENTANMELDUNG**

(21) Anmeldenummer: **89105841.4**

(22) Anmeldetag: **04.04.89**

(51) Int. Cl.4: **H01H 13/70 , H05K 9/00**

(30) Priorität: **04.06.88 DE 3819143**

(43) Veröffentlichungstag der Anmeldung:
**13.12.89 Patentblatt 89/50**

(84) Benannte Vertragsstaaten:
**AT BE CH DE ES FR GB GR IT LI LU NL SE**

(71) Anmelder: **HAGENUK GMBH**
**Westring 431**
**D-2300 Kiel 1(DE)**

(72) Erfinder: **Ziebell, Gerd**
**Gildeweg 12a**
**D-2301 Osdorf(DE)**

(74) Vertreter: **Hansmann, Dierk, Dipl.-Ing.**
**Jessenstrasse 4**
**D-2000 Hamburg 50(DE)**

(54) **Schaltungsträger für elektrische Bauelemente als Schaltfolien, Platinen oder dergleichen.**

(57) Zur Erzielung einer ESD-Festigkeit ist vorgesehen, Schaltungsträger, insbesondere Schaltfolien mit einer elektrisch isolierenden Abdeckfolie zu versehen. Dabei ist vorgesehen, im Bereich von Bauelementen Ausprägungen vorzusehen, die entsprechende Aufnahmeräume bilden.

FIG. 2

Schaltungsträger für elektrische Bauelemente als Schaltfolien, Platinen oder dergleichen

Die Erfindung bezieht sich auf einen Schaltungsträger für elektrische Bauelemente als Schaltfolien, Platinen oder dergleichen, insbesondere zum Einsatz in Bedienungstafeln mit vorstehenden Bauelementen, wie Anzeigemittel in Form von LED-Elementen.

Bei Anordnungen dieser Art hat sich gezeigt, daß Probleme bestehen, wenn die Vorschriften über eine ESD-Festigkeit der Bauelemente erfüllt werden sollen. ESD heißt Electrostatic Discharge und es bedeutet, daß die Störfestigkeit von Geräten gegen Entladung statischer Elektrizität nachgewiesen werden muß. Dieser Schutz muß gemäß entsprechenden Vorschriften gewährleistet werden und wird insbesondere bei Bedienungstafeln von Geräten, wie Fernsprechgeräten, nur mit großem Aufwand gewährleistet, da hierbei es erforderlich ist, die Leuchtpunkte so weit wie möglich hervorzuheben. Beim Einsatz von Schaltfolien bestehen besondere Probleme, da sich keine Möglichkeit ergibt, eine Anordnung in Ausschnitten vorzunehmen.

Die Aufgabe ist es, eine gattungsgemäße Anordnung zu schaffen, die ohne großen Aufwand eine ESD-Festigkeit gewährleistet sowie gleichzeitig einen Schutz für Leiterbahnen und Bauelemente ermöglicht, wobei unter Berücksichtigung der Anforderungen auch eine Hervorhebung von Leuchtpunkten durchführbar ist.

Die Lösung dieser Aufgabe erfolgt erfindungsgemäß dadurch, daß eine elektrisch isolierende Abdeckfolie auf dem Schaltungsträger aufbringbar ist, die im Bereich der Bauelemente Ausprägungen zur Bildung von Aufnahmeräumen aufweisen.

Hierdurch werden auf einfache Weise die entsprechenden Schutzbedingungen gewährleistet und auch Leiterbahnen sowie Bauteile geschützt, wobei es möglich ist, Leuchtpunkte so hoch wie möglich der Bedieneroberfläche zuzuordnen. Es wird auch möglich, daß die Bedienung von integrierten Schaltkontakten in den Schaltungsträger durch die Abdeckfolie nicht beeinträchtigt werden.

Eine einfache Ausbildung wird dadurch geschaffen, daß die Abdeckfolie mit dem Schaltungsträger über eine Klebung verbindbar ist.

Ferner wird vorgeschlagen, daß die Abdeckfolie, wie eine Polyester-Folie, mindestens im Bereich der Bauelemente als Anzeigeelemente durchsichtig ist.

Eine günstige Ausgestaltung besteht darin, daß die Abdeckfolie unter Zwischenschaltung einer Distanzfolie mit beidseitigen Klebeschichten aufweist und Aussparungen in der Distanzfolie im Bereich der Bauelemente angeordnet sind.

In der Zeichnung ist ein Ausführungsbeispiel der Erfindung mit einer Schaltfolie schematisch dargestellt. Es zeigen:

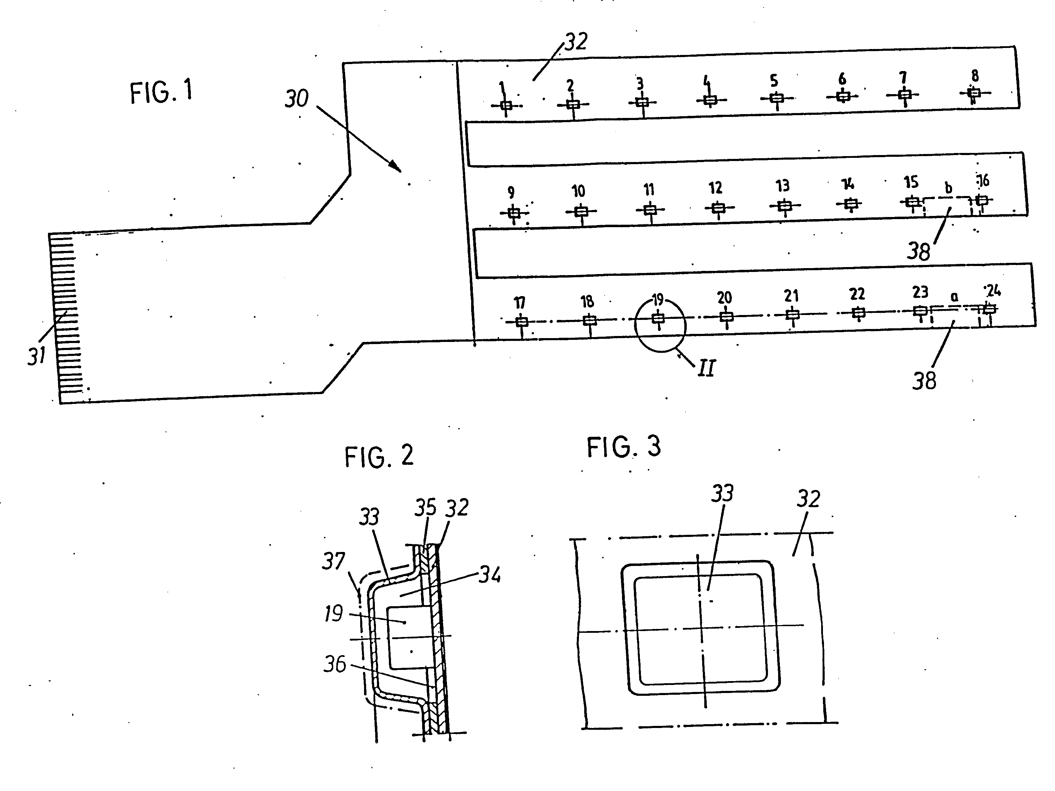

Fig. 1 eine Draufsicht auf eine Schaltfolie mit einer Vielzahl von Anzeigemitteln und integrierten Schaltkontakten, die durch eine Abdeckfolie versehen ist,

Fig. 2 eine Schnittdarstellung auf einen Ausschnitt II der Fig. 1 in vergrößerten Maßstab,

Fig. 3 eine Draufsicht gemäß Fig. 2.

Die dargestellte Anordnung besteht aus einer Schaltfolie 30 mit einem Anschlußstück 31, wobei eine Vielzahl von Anzeigemittel 1 bis 24 in Form von LED-Elementen auf der Schaltfolie 30 angeordnet sind. Weiterhin sind Schaltkontakte 38 in der Schaltfolie 30 integriert. Die entsprechenden Leiterbahnen und Elemente sind durch eine Polyester-Folie als Abdeckfolie 32 abgedeckt, um eine ausreichende ESD-Festigkeit zu erzielen. In diesem Fall ist die Schaltfolie 30 für eine Bedienungstafel eingesetzt.

Die Abdeckfolie 32 ist mit Ausprägungen 33 versehen, die den Anzeigemitteln 1 bis 24 zugeordnet sind und entsprechende Aufnahmeräume 34 bilden.

Bei dieser Ausbildung ist auf der Abdeckfolie 32 eine Distanzfolie 35 aufgebracht, die beiderseits Klebeschichten aufweist und im Bereich der Anzeigemittel 1 bis 24 zugeordnete Aussparungen 36 aufweist und über die Klebeschichten einmal eine Verbindung zur Abdeckfolie 32 sowie zum anderen zur Schaltfolie 30 aufweist.

Die Abdeckfolie 32 ist dabei im gekennzeichneten Bereich 37 durchsichtig ausgebildet, um die entsprechende Leuchtkraft der Anzeigemittel 1 bis 24 nicht zu beeinträchtigen.

## Ansprüche

1. Schaltungsträger für elektrische Bauelemente als Schaltfolien, Platinen oder dergleichen, insbesondere zum Einsatz in Bedienungstafeln mit vorstehenden Bauelementen, wie Anzeigemittel in Form LED-Elementen, dadurch gekennzeichnet, daß eine elektrisch isolierende Abdeckfolie (32) auf dem Schaltungsträger (30) aufbringbar ist, die im Bereich der Bauelemente (1-24) Ausprägungen (33) zur Bildung von Aufnahmeräumen (34) aufweisen.

2. Schaltungsträger nach Anspruch 1, dadurch gekennzeichnet, daß die Abdeckfolie (32) mit dem Schaltungsträger (30) über eine Klebung verbindbar ist.

3. Schaltungsträger nach Anspruch 1 oder 2, dadurch gekennzeichnet, daß die Abdeckfolie (32), wie eine Polyester-Folie, mindestens im Bereich (37) der Bauelemente (1-24) als Anzeigeelemente durchsichtig ist.

4. Schaltungsträger nach einem der Ansprüche (1-3) dadurch gekennzeichnet, daß die Abdeckfolie (32) unter Zwischenschaltung einer Distanzfolie (35) mit beidseitigen Klebeschichten aufweist und Aussparungen (36) in der Distanzfolie (35) im Bereich der Bauelemente (1-24) angeordnet sind.

FIG. 1

FIG. 2

FIG. 3